# EUROPEAN PATENT APPLICATION

(11) **EP 4 293 715 A1**
(43) Date of publication of application: **20.12.2023**
(21) Application number: 22179235.1
(22) Date of filing: 15.06.2022
(51) Int. Cl.: H01L 23/495, H01L 23/31

(54) **A METHOD FOR MANUFACTURING A SEMICONDUCTOR PACKAGE ASSEMBLY AS WELL AS SUCH SEMICONDUCTOR PACKAGE ASSEMBLY**

(71) Applicant: Nexperia B.V., 6534 AB Nijmegen (NL)
(72) Inventor: Lee, Wai Wai, Seremban (MY); Chang, Ting Wei, Seremban (MY); Ting, Jia Yunn, Seremban (MY); Tan, Wei Leong, Seremban (MY)
(74) Representative: Pjanovic, Ilija

(57) **Abstract**

The disclosure proposes a method for manufacturing a semiconductor package assembly comprising the steps of i) forming at least one semiconductor package by means of the sub-steps: i1) providing a lead frame having a first frame side and a second frame side opposite to the first frame side; i2) adhering at least one semiconductor die structure having a first die side and a second die side opposite to the first side with its second die side on the first frame side of the lead frame, resulting in a first conductive connection between the lead frame and the at least one semiconductor die structure; i3) adhering at least one bond element on the first die side of the at least one semiconductor die structure and/or on the first frame side of the lead frame, resulting in at least one further conductive connection between the at least one bond element and the at least one semiconductor die structure and between at least a further bond element and the lead frame; and ii) encapsulating the at least one semiconductor package with a moulding resin, thereby forming at least one encapsulated semiconductor package assembly; wherein, prior to step ii) but after step i3), the method further comprises the step of: iii) subjecting the exposed surfaces of the first frame side of the lead frame, the adhering connections and the at least one bond element of the at least one semiconductor package to a surface roughening treatment using a chemical solution.

## Description

### TECHNICAL FIELD

The present disclosure relates to a method for manufacturing a semiconductor package assembly, the assembly consisting of a semiconductor package and a moulding resin case encapsulating the semiconductor package. The disclosure also relates to a semiconductor package assembly as manufactured with the method according to the disclosure.

### BACKGROUND OF THE DISCLOSURE

Nowadays, customer requirements are getting more stringent in order to develop a high-power semiconductor package assembly. High-power semiconductor package assemblies are known to be more sensitive to moisture ingression and ionic contaminations which are induced by delamination. For obtaining a robust high-power semiconductor package assembly, delamination of the moulding resin case from the semiconductor package has to be avoided at all costs.

Accordingly, preventing or limiting the occurrence of delamination in a semiconductor package assembly can be improved by enhancing the adhesion between the semiconductor package and the moulding resin (the Epoxy Molding Compound or EMC) and reducing mechanical stress during the assembly process. In enhancing the adhesion aspect, surface morphology of the semiconductor package is one of the key influences to limit the effect of delamination and this is commonly achieved by roughening the lead frame.

Roughening the surface of the lead frame is commonly executed at the supplier site, yet one of the disadvantages are costs, which is higher due to additional etching and finishing process. In addition, roughened surfaces may cause negative impact on solder wettability issues and pattern recognition (PR) issues in DACA (Die Attach Clip Attach) processes.

Accordingly, it is a goal of the present disclosure to provide a method for manufacturing a semiconductor package assembly as well as such semiconductor package assembly, wherein an improved adhesion between the semiconductor package and the moulding resin case encapsulating the semiconductor package is achieved and wherein the effects of delamination are significantly reduced.

### SUMMARY OF THE DISCLOSURE

According to a first example of the disclosure, a method for manufacturing a semiconductor package assembly is proposed, with the method comprising the steps of
i) forming at least one semiconductor package by means of the sub-steps:
   i1) providing a lead frame having a first frame side and a second frame side opposite to the first frame side;
   i2) adhering at least one semiconductor die structure having a first die side and a second die side opposite to the first side with its second die side on the first frame side of the lead frame, resulting in a first conductive connection between the lead frame and the at least one semiconductor die structure;
   i3) adhering at least one bond element on the first die side of the at least one semiconductor die structure and/or on the first frame side of the lead frame, resulting in at least one further conductive connection between the at least one bond element and the at least one semiconductor die structure and between at least a further bond element and the lead frame;
      and
ii) encapsulating the at least one semiconductor package with a moulding resin, thereby forming at least one encapsulated semiconductor package assembly;
wherein, prior to step ii but after step i3, the method further comprises the step of:
iii) subjecting the exposed surfaces of the first frame side of the lead frame, the adhering connections and the at least one bond element of the at least one semiconductor package to a surface roughening treatment using a chemical solution.

Accordingly, with this technique the complete semiconductor package undergoes a surface roughening treatment, thus improving the overall adhesion with the moulding resin (EMC) and reducing the risks of delamination. Also, herewith the adverse effects of surface roughening of the lead frame only are obviated as well as its corresponding negative impact on solder wettability issues and pattern recognition (PR) issues in DACA (Die Attach Clip Attach) processes.

In a detailed example, the chemical solution is an organic or inorganic cleaning agent, for example a photoresist layer stripping agent. In particular, the photoresist layer stripping agent can be an aqueous, a solvent or a semi-aqueous agent.

In an example, the roughening step iii) consists of submerging the at least one semiconductor package in the chemical solution for a period of at least 10 minutes.

Additionally, by performing the surface roughening of the surface of the complete semiconductor package during the submerging step iii) at an elevated temperature of at least 10°C below the flashpoint temperature of the chemical solution used, the resulting adhesion of the moulding resin (EMC) with the surface roughened semiconductor package is improved significantly.

In a further detail of the method according to the disclosure, it further comprises the steps, which are performed prior to the encapsulating step ii) but after the surface roughening step iii) of:
iv) rinsing the semiconductor package with deionized water and;
v) drying the semiconductor package.

Alternatively, after the encapsulating step ii), the method according to the disclosure may comprise the steps of:
vi) plating the exposed lead frame;
vii) singulating the at least one encapsulated semiconductor package assembly, thereby obtaining a single encapsulated semiconductor package assembly with a moulding resin case having an improved adhesion with the encapsulated semiconductor package and consequently a reduced risk of delamination.

In another example of the disclosure, a semiconductor package assembly is proposed , which has been obtained with the method according to the disclosure and outlined in this application.

### BRIEF DESCRIPTION OF THE DRAWINGS

The disclosure will now be discussed with reference to the drawings, which show in:
Figure 1 a flow chart depicting the relevant steps of an example of the method according to the disclosure;
Figures 2 and 3 two examples showing details of a semiconductor package assembly as obtained with the method according to the disclosure;
Figure 4 details showing a comparison between a semiconductor package assembly according to the state of the art and a semiconductor package assembly as obtained with the method according to the disclosure.

### DETAILED DESCRIPTION OF THE DISCLOSURE

For a proper understanding of the disclosure, in the detailed description below corresponding elements or parts of the disclosure will be denoted with identical reference numerals in the drawings.

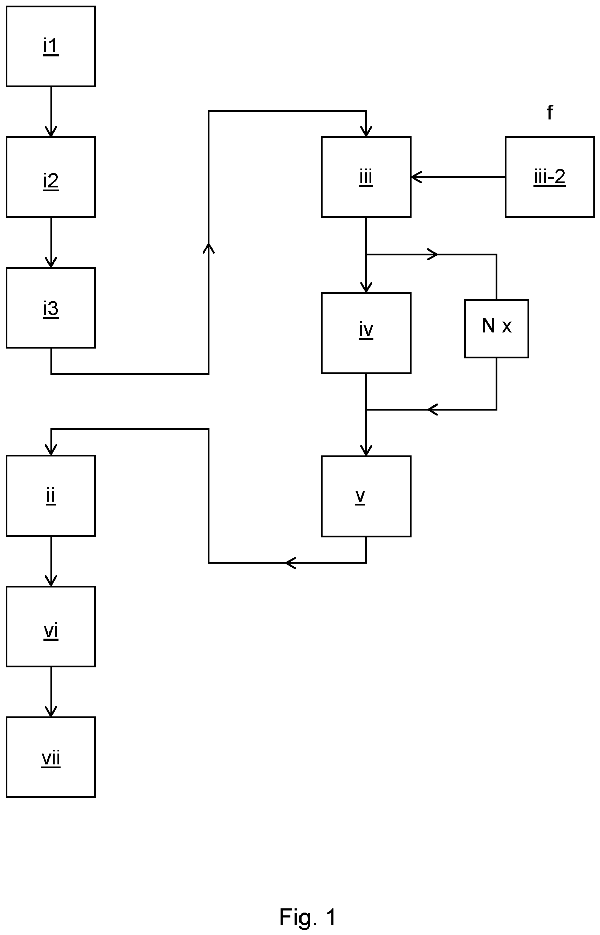

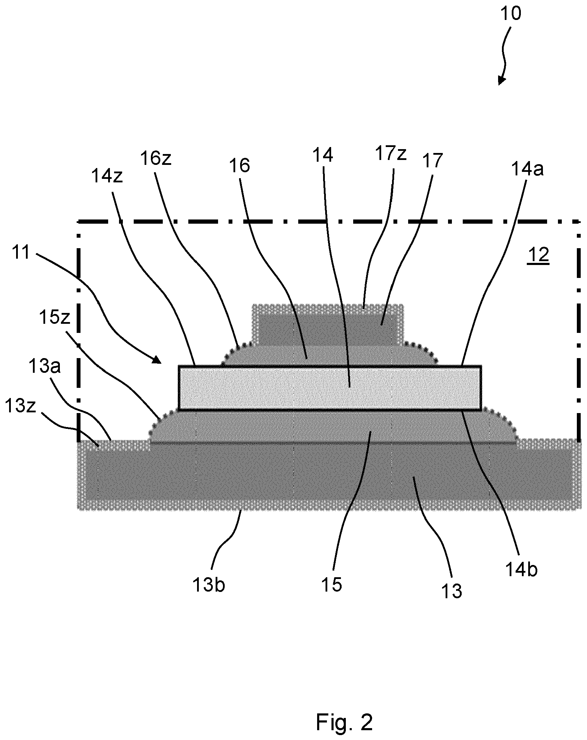

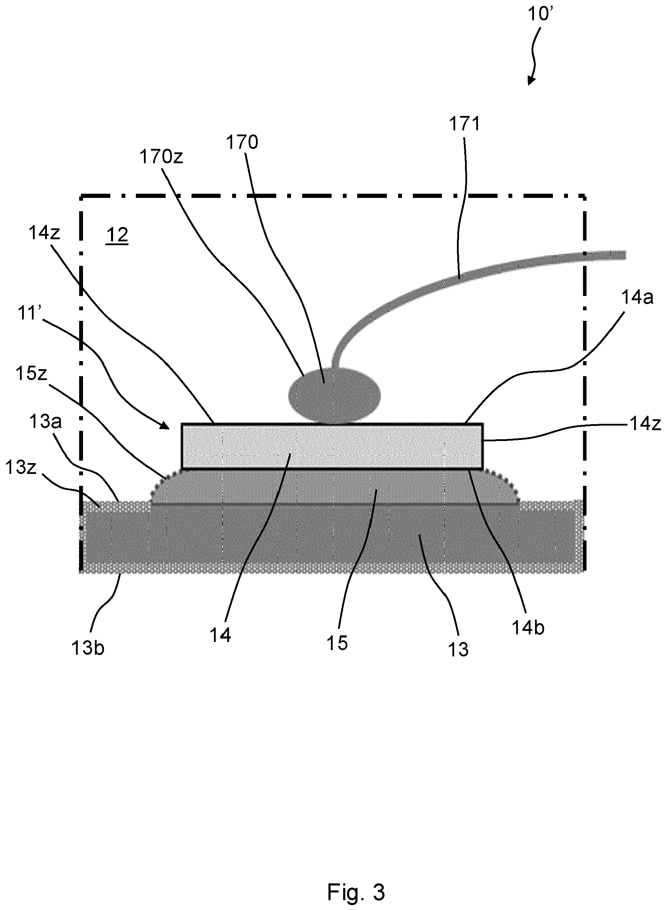

In Figure 1 a flow chart is shown, which depicts the relevant steps of an example of the method according to the disclosure. The reference numerals denoted below when outlining the method steps according to the disclosure, reference is made to Figures 2 and 3.

In a first steps at least one semiconductor package (reference numeral 11 in Figure 2, 11' in Figure 3) is formed by means of the sub-steps i1) providing a lead frame 13 having a first frame side 13a and a second frame side 13b opposite to the first frame side 13a. The lead frame 13 is preferably made from a copper material plate. Following the sub-step i1, in a sub-step i2 at least one semiconductor die structure 14 is adhered to the lead frame 13. In general at least one semiconductor die structure 14 has a first die side 14a and a second die side 14b opposite to the first side 14a and the adhering step i2 is performed by adhering the second die side 14b on the first frame side 13a of the lead frame 13.

The adhering step i2 can be performed with any suitable adhering principle used in semiconductor package manufacturing. For example, a glue connection or a soldering connection can be implemented, as long as step i2 results in a first conductive connection 15 between the lead frame 13 and the at least one semiconductor die structure 14.

Similarly, in a further adhering step i3 at least one bond element is adhered on the first die side 14a of the at least one semiconductor die structure 14 and/or on the first frame side 13a of the lead frame 13. Likewise, in step i3, any suitable adhering principle can be used in semiconductor package manufacturing, such as a glue connection or a soldering connection. In either way, also step i3 results in at least one further conductive connection 16 between the at least one bond element and the at least one semiconductor die structure 14 and between at least a further bond element and the lead frame 13. As to the type of bond element used, in an example of step i3, a bond clip 17 (Figure 2) is adhered to the semiconductor die structure 14 thus forming the further conductive connection 16, whereas in Figure 3, the result of step i3 is a further conductive connection being formed of a contact pad or ball bond 170 adhered to the first die side 14a of the semiconductor die structure 14, further completed with the adhering of a bond wire 171 to the contact pad or ball bond 170.

After establishing all conductive connections 15 and 16 (depicted in either Figure 2 and 3), the encapsulated semiconductor package assembly 10-10' is created in step ii by encapsulating the at least one semiconductor package 11-11' with a moulding resin case 12 (EMC, or Epoxy Molding Compound).

In order to prevent or limit the occurrence of delamination in the semiconductor package assembly 10-10' between the moulding resin (EMC) and the semiconductor package 11-11' the adhesion between both parts of the semiconductor package assembly 10-10' has to be improved and according to the disclosure a step iii is proposed, wherein the exposed surface 13z of the first frame side 13a of the lead frame 13, the exposed surfaces 15z-16z of the adhering conductive connections 15-16, the exposed surface 14z of the semiconductor die structure 14 and the exposed surfaces 17z-170z of the bond elements 17-170 of the at least one semiconductor package 11-11' are subjected to a surface roughening treatment using a chemical solution.

It is essential to note that the surface roughening treatment step iii is performed prior to the encapsulating step ii, but after the adhering step i3 of adhering the at least one bond element 17 (170-171) on the first die side 14a of the at least one semiconductor die structure 14 and/or on the first frame side 13a of the lead frame 13.

Alternatively, it is also noted that the step i3 of adhering the bond wire 171 to the contact pad or ball bond 170 can be performed before or after the roughening treatment step iii. The roughening of a bond wire 171 is only applicable if the wire bonding step is performed before the chemical treatment.

Accordingly, with the surface roughening treatment of step iii all outer surfaces 13z-14z-15z-16z-17z-170z of the complete semiconductor package 11-11' undergo a surface roughening treatment prior to its encapsulation with the EMC moulding resin case 12. The overall adhesion with the moulding resin (EMC) 12 is thus significantly improved and any risk of delamination between (the outer surface of) the semiconductor package 11-11' and the EMC 12 is reduced. Also, the adverse effects of surface roughening of the lead frame 13 in advance at the supplier site are obviated as well as its corresponding negative impact on solder wettability issues and pattern recognition (PR) issues in DACA (Die Attach Clip Attach) processes.

The chemical solution used in step iii can be an organic or inorganic cleaning agent. It has been discovered that preferably a photoresist layer stripping agent is highly beneficial for performing the step iii. In particular, the photoresist layer stripping agent can be an aqueous, a solvent or a semi-aqueous agent.

In a beneficial application step, it has been found the roughening step iii should involve submerging the at least one semiconductor package 11-11' in the chemical solution and exposing its outer surfaces 13z-14z-15z-16z-17z-170z for a period of at least 10 minutes. As examples of beneficial time frames, the step iii of submerging and exposing the outer surfaces 13z-14z-15z-16z-17z-170z is to be performed during a time frame of at least 10 minutes .

Additionally, by performing the surface roughening of the exposed surfaces 13z-14z-15z-16z-17z-170z of the complete semiconductor package 11 (11') during the submerging step iii) at an elevated temperature of at least 10°C below the flashpoint temperature of the chemical solution used, the resulting adhesion of the moulding resin (EMC) with the surface roughened semiconductor package 11-11' is improved significantly. Elevated temperatures will increase the chemical reaction rate and increase the roughening effect while too high temperature will cause fire hazards since the flash point is minimum temperature where chemical gives off vapor to form an ignitable mixture with the air near the surface of the liquid.

Subsequently, the method according to the disclosure is finalized after the surface roughening step iii, but prior to the encapsulating step ii by step iv, wherein the roughened semiconductor package 11-11' is rinsed with deionized water, and subsequently dried during a step v.

Finally, after the encapsulating step ii, the method according to the disclosure comprises the step vi of plating the exposed lead frame ends and singulating in step vii the at least one encapsulated semiconductor package assembly, thereby obtaining a single encapsulated semiconductor package assembly 10-10' with a moulding resin case 12 having an improved adhesion with the roughened yet encapsulated semiconductor package 11-11' and consequently a reduced risk of delamination.

Although already referenced above when describing the method steps according to the disclosure, Figures 2 and 3 disclose two examples of a semiconductor package assembly as obtained with the method according to the disclosure. These examples are denoted with reference numeral 10 (Figure 2) and 10' respectively (Figure 3). The semiconductor package assemblies 10-10' as shown in Figures 2 and 3 are conventional lead frame-based IC package assemblies. The main part is the semiconductor package, indicated with reference numeral 11 in Figure 2 and reference numeral 11' in Figure 3. The semiconductor package 11 (11') includes in a non-limited example, a lead frame 13 having a first frame side 13a and a second frame side 13b, the latter being positioned opposite to the first frame side 13a. In the Figures, the first frame side 13a can be classified as the upper or top side, whereas the second frame side 13b opposite to the first frame side 13a can be classified as the bottom or lower side. The lead frame 13 is in an example made from copper plate material.

Reference numeral 14 denotes a semiconductor die structure having a first (top or upper) die side 14a and a second (bottom or lower) die side 14b opposite to the first side 14a. The semiconductor die structure 14 is provided or mounted with its lower, second die side 14b on the upper, first frame side 13a of the lead frame 13. The mounting can be facilitated by means of an adhering connection, e.g. a glue connection or a soldering connection 15, which, during manufacturing, as outlined in step i2 of the method according to the disclosure, is provided between the lower, second die side 14b and the upper, first frame side 13a.

In both examples of Figures 2 and 3, conformal to step i3 of the method of the disclosure, one or more bond elements are electrically connecting the semiconductor die structure 14 with e.g. the lead frame 13. Accordingly, as shown in Figure 2, the semiconductor die structure 14 is on its first (top or upper) die side 14a provided with one or more bond elements 17, which are construed as bond clips 17. The bond clips 17 in this example are provided on the upper, first die side 14a with the assistance of the adhering connection 16, e.g. through gluing or soldering.

Alternatively, as shown in Figure 3, one or more bond wires 171 can be electrically connected via a contact pad or ball bond 171 with the first die side 14a of the semiconductor die structure 14 using suitable known semiconductor connecting techniques. Each bond wire 171 can be electrically connected with a frame lead (not shown) of the lead frame 13.

When performing the surface roughening treatment of step iii of the method according to the disclosure, all exposed outer surfaces 13z-14z-15z-16z-17z-170z of the first frame side 13a of the lead frame 13, the adhering conductive connections 15-16, the semiconductor die structure 14 and the bond elements 17-170 of the at least one complete semiconductor package 11-11' are surface roughened treatment prior to their encapsulation with the EMC moulding resin case 12.

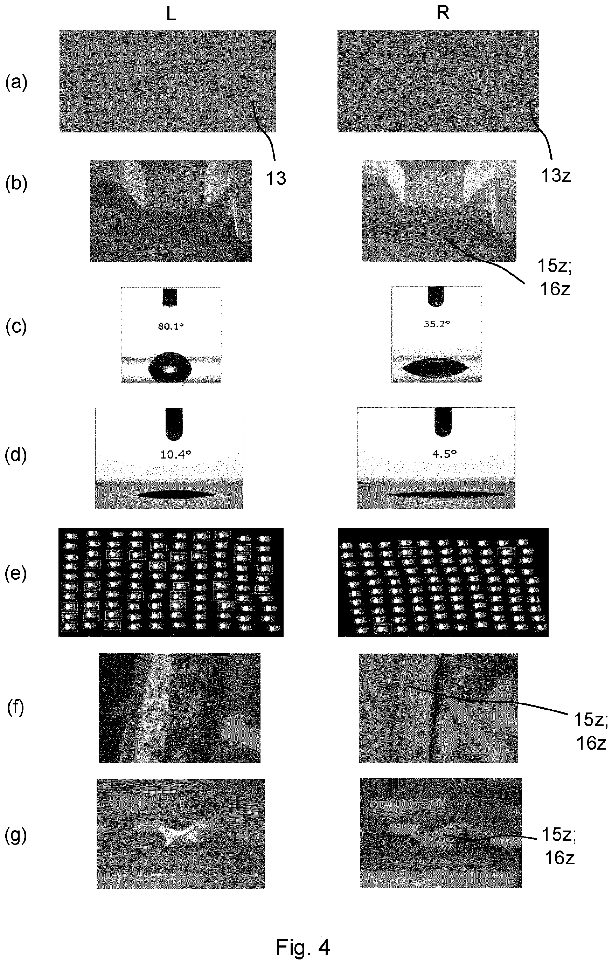

The results of the surface roughening step iii are for example shown in Figure 4, which shows in its left column L surface SEM (scanning electron microscope) pictures of various parts of a semiconductor package according to the state of art, and in its right column R SEM (scanning electron microscope) pictures of corresponding parts of a semiconductor package, which underwent the surface roughening treatment of to the method according to the disclosure.

Figure 4a depicts the differences in surface roughness 13z-17z of a surface side 13a of a lead frame 13 according to the state of the art (LEFT) and according to the method of the disclosure (RIGHT). It is noted that the surface 13z in the right column exhibits a more irregular surface roughness and hence an improved adhesion than the surface according to the state of the art in the left column.

Figure 4b depicts the differences in surface roughness 15z-16z of the adhering conductive connections 15-16, according to the state of the art (LEFT) and according to the method of the disclosure (RIGHT). It is noted that the surface in the right column exhibits a more irregular surface roughness and hence an improved adhesion than the surfaces according to the state of the art in the left column.

Figures 4c and 4d depict the differences as the contact angles on the lead frame surface 13a (Figure 4c: 80.1° in the left column versus 33.2° in the right column) and the differences as the contact angles on die surface side 14a (Figure 4d: 10.4° in the left column versus 4.5° in the right column). In both Figures, the pictures in the right column show that the surface treated surfaces have reduced contact angles compared to the untreated surfaces according to the state of the art in the left column. Accordingly, the surfaces which have undergone the surface roughening treatment of the method according to the disclosure have a smaller contact surface, hence an improved adhesion with the molding resin case 12 and accordingly a reduced delamination.

The reduction in delamination is shown in Figure 4e, wherein the delamination occurrence has been reduced from 30% in the untreated surface in the left column to 3% in the surface roughened surface in the right column.

Similarly, Figures 4f and 4g pertain to the decapping or removal of the molding resin case 12 from the semiconductor package assembly in order to expose the semiconductor die structure 14. Figure 4f pertains to mechanical decapping, whereas Figure 4g pertains to chemical decapping. In both decapping techniques, the right column shows that after decapping the exposed roughened surfaces 15z-16z of the adhering conductive connections 15-16 as treated with the method according to the disclosure exhibit a rougher surface, than the unroughened surfaces of the corresponding parts in a semiconductor package assembly according to the state of art.

In the lead frame roughening according to the prior art, particularly Cu lead frame is achieved through chemical etching which consists of acids like H₂SO₄, H₂O₂ or a mixture of it. These acids are etchant and potentially will etch/attack the die top metal typically AlCu/TiNiAg which eventually will cause poor contact and reliability issue. In the invention, we are using the chemical which is generally safe/compatible with the die structure preferably a photo resist stripper which will not attack the die top metal/surface at the same time have substantial roughening effect to the lead frame surface typically of Cu lead frame and interconnects.

### LIST OF REFERENCE NUMERALS USED

- 10, 10': encapsulated semiconductor package assembly (first and second example)
- 11, 11': semiconductor package (first and second example)
- 12: moulding resin case
- 13: lead frame
- 13a: first frame side of lead frame
- 13b: second frame side of lead frame
- 13z: roughened exposed surface of lead frame
- 14: semiconductor die structure
- 14a: first die side of semiconductor die structure
- 14b: second die side of semiconductor die structure
- 14z: roughened exposed surface of semiconductor die structure
- 15: first conductive, metallic connection
- 15z: roughened exposed surface of first conductive, metallic connection
- 16: further conductive, metallic connection
- 16z: roughened exposed surface of further conductive, metallic connection
- 17: bond clip
- 17z: roughened exposed surface of bond clip
- 170: contact pad (second embodiment)
- 170z: roughened exposed surface of contact pad
- 171: bond wire (second embodiment)

## Claims

1. A method for manufacturing a semiconductor package assembly, the method comprising the steps of
i) forming at least one semiconductor package by means of the sub-steps:
i1) providing a lead frame having a first frame side and a second frame side opposite to the first frame side;
i2) adhering at least one semiconductor die structure having a first die side and a second die side opposite to the first side with its second die side on the first frame side of the lead frame, resulting in a first conductive connection between the lead frame and the at least one semiconductor die structure;
i3) adhering at least one bond element on the first die side of the at least one semiconductor die structure and/or on the first frame side of the lead frame, resulting in at least one further conductive connection between the at least one bond element and the at least one semiconductor die structure and between at least a further bond element and the lead frame;
and
ii) encapsulating the at least one semiconductor package with a moulding resin, thereby forming at least one encapsulated semiconductor package assembly;
wherein, prior to step ii but after step i3, the method further comprises the step of:
iii) subjecting the exposed surfaces of the first frame side of the lead frame, the adhering connections and the at least one bond element of the at least one semiconductor package to a surface roughening treatment using a chemical solution.

2. The method according to claim 1, wherein the chemical solution is an organic or inorganic cleaning agent, for example a photoresist layer stripping agent.

3. The method according to claim 2, wherein the photoresist layer stripping agent can be an aqueous, a solvent or a semi-aqueous agent.

4. The method according to any one or more of the claims 1-3, wherein step iii) of roughening consists of submerging the at least one semiconductor package in the chemical solution for a period of at least 10 minutes, in particular 20-40 minutes, in particular about 30 minutes.

5. The method according to claim 4, wherein the submerging step iii) is performed at an elevated temperature of at least 10°C below the flashpoint temperature of the chemical solution used.

6. The method according to any one or more of the claims 1 to 5, wherein, prior to the encapsulating step ii) but after the surface roughening step iii) the method further comprises the steps of:
iv) rinsing the semiconductor package with deionized water;
v) drying the semiconductor package.

7. The method according to any one or more of the claims 1 to 6, further comprising, after the encapsulating step ii), the steps of:
vi) plating the exposed lead frame;
vii) singulating the at least one encapsulated semiconductor package assembly.

8. A semiconductor package assembly as obtained with the method according to any one or more of the preceding claims.
